(19) Europäisches Patentamt European Patent Office Office européen des brevets

(11) **EP 1 892 323 B1**

(12) **EUROPEAN PATENT SPECIFICATION**

(45) Date of publication and mention of the grant of the patent:
**11.05.2016 Bulletin 2016/19**

(51) Int Cl.:
*C30B 15/04* (2006.01)    *C30B 15/20* (2006.01)
*C30B 29/06* (2006.01)    *H01L 21/322* (2006.01)

(21) Application number: **05783521.7**

(22) Date of filing: **14.09.2005**

(86) International application number:
**PCT/JP2005/016961**

(87) International publication number:
**WO 2006/112053 (26.10.2006 Gazette 2006/43)**

(54) **SILICON SINGLE CRYSTAL GROWING METHOD**

VERFAHREN ZUM ZIEHEN VON SILICIUMEINKRISTALLEN

PROCEDE DE CROISSANCE DE MONOCRISTAL DE SILICIUM

(84) Designated Contracting States:
**DE**

(30) Priority: **08.04.2005 JP 2005112649**
**13.07.2005 JP 2005203865**

(43) Date of publication of application:
**27.02.2008 Bulletin 2008/09**

(60) Divisional application:
**10002649.1 / 2 194 168**

(73) Proprietor: **SUMCO Corporation**
**Tokyo 105-8634 (JP)**

(72) Inventors:
• **Ono, Toshiaki**
  **Tokyo 1058634 (JP)**
• **Sugimura, Wataru**
  **Tokyo 1058634 (JP)**
• **Hourai, Masataka**
  **Tokyo 1058634 (JP)**

(74) Representative: **Bertsch, Florian Oliver**
**Kraus & Weisert**
**Patentanwälte PartGmbB**
**Thomas-Wimmer-Ring 15**
**80539 München (DE)**

(56) References cited:
EP-A- 1 785 511        WO-A-2004/083496
WO-A1-2004/083496      JP-A- 11 189 495
JP-A- 2000 281 491     JP-A- 2002 134 517
JP-A- 2002 187 794     US-A1- 2001 023 941
US-B1- 6 663 708

**Description**

TECHNICAL FIELD

The present invention relates to a method for growing silicon single crystal which is a raw material for a silicon wafer used as a substrate for semiconductor integrated circuit, and a silicon wafer produced from the silicon single crystal.

BACKGROUND ART

To manufacture a single crystal of silicon, from which a silicon wafer used for a substrate for semiconductor integrated circuit (device) is cut out, a growing method by the Czochralski process (hereinafter referred to as CZ process) has been most commonly adopted. The CZ process comprises the step of growing a silicon single crystal by immersing and pulling up seed crystal in and from molten silicon within a quartz crucible, and the progress of this growing technique enables production of a dislocation-free large silicon single crystal with least defects.

A semiconductor device is made into a product through a number of processes for circuit formation by using a wafer obtained from silicon single crystal as a substrate. In these processes, many physical treatments, chemical treatments and further thermal treatments are applied, including a fierce treatment at a temperature exceeding 1000°C. Therefore, a micro defect, which is caused at the time of growing the silicon single crystal manifests itself in the manufacturing process of the device to significantly affect the performance of the device, i.e., the Grown-in defect becomes a problem.

In order to produce a wafer free from the Grown-in defect, it has been adopted to perform a thermal treatment to the wafer after forming, in which the defect-free part obtained thereby is limited to a surface layer part thereof. Accordingly, in order to ensure a sufficiently defect-free area up to a position deep from the surface, the defect-free part must be formed in the silicon single crystal growing stage. Such a defect-free silicon single crystal has been obtained by use of a growing method with an improved structure of a part of silicon single crystal to be the raw material, that is cooled just after solidification in pulling operation, i.e., a hot zone, and by a process for adding hydrogen to an apparatus internal atmosphere during growing.

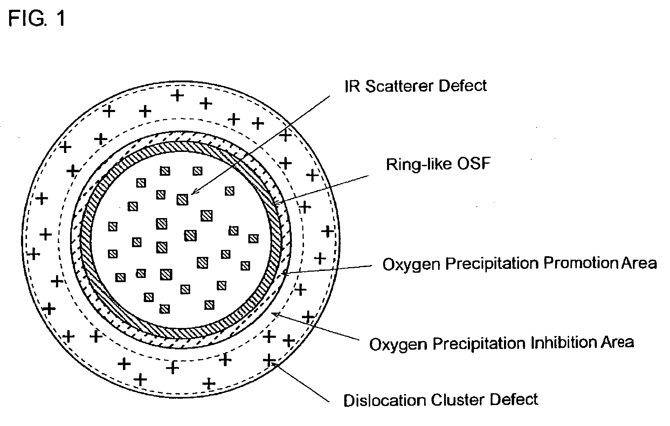

Fig. 1 is a view illustrating a typical distribution of the Grown-in defects present in a silicon single crystal obtained by the CZ process. The Grown-in defects of silicon single crystal obtained by the CZ process include a vacancy defect with a size of about 0.1-0.2 $\mu$m called a defective infrared ray (IR) scatterer or COP (crystal originated particle) and a defect consisting of minute dislocations with a size of about 10 $\mu$m called a dislocation cluster. The distribution of these defects in general pulling-growing process is observed, for example, as shown in Fig. 1. This drawing schematically shows the result of distribution observation for the micro defects by X-ray topography, which was cut from silicon single crystal in as-grown state along the plane perpendicular to the pulling axis, immersed in an aqueous solution of copper nitrate to deposit Cu onto the wafer, and then thermally treated.

In this wafer, an oxygen induced stacking fault (hereinafter referred to as OSF) distributed in a ring shape emerges in a position of about 2/3 of the outer diameter, about $10^5$-$10^6$ pieces/cm$^3$ of IR scatterer defects are detected on the inside area of this ring, and about $10^3$-$10^4$ pieces/cm$^3$ of dislocation cluster defects are present on the outside area thereof.

The OSF is a stacking defect by interstitial atom caused in an oxidation thermal treatment, and its generation and growing on the wafer surface that is the device active area causes a leak current to deteriorate device characteristics. The IR scatterer is a factor causing deterioration of initial gate oxide integrity, and the dislocation cluster also causes a characteristic failure of the device formed thereon.

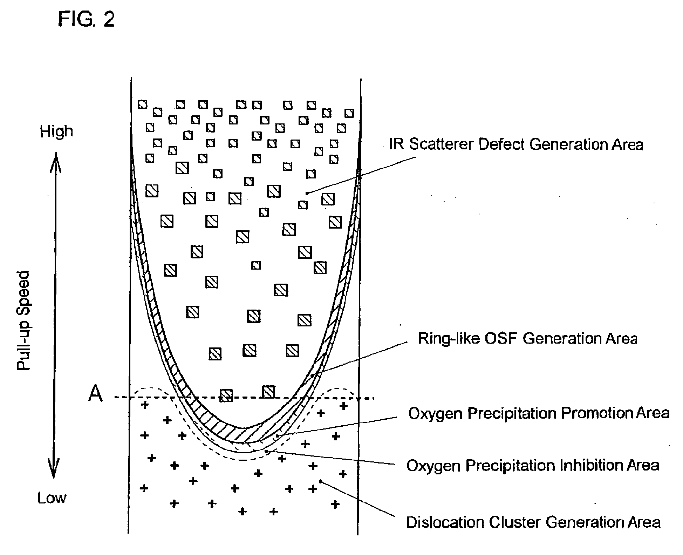

Fig. 2 is a view schematically showing a general relation between pull-up speed and crystal defect generation position in pulling silicon single crystal with reference to the defect distribution state in a section of silicon single crystal grown when the pull-up speed is gradually reduced. In general, the defect generation state is greatly affected by the pull-up speed in growing the silicon single crystal and the internal temperature distribution of the silicon single crystal just after solidification. For example, when the silicon single crystal grown while gradually reducing the pull-up speed is cut along the pulling axis of the crystal center, and this section is examined for defect distribution in the same manner as Fig. 1, the result shown in Fig. 2 can be obtained.

In observation of a plane perpendicular to the pulling axis of the silicon single crystal, in a stage with high pull-up speed at trunk part after forming a shoulder part to have a required silicon single crystal diameter, the ring-like OSF is present in the periphery of the crystal, while many IR scatterer defects are generated on the inside area. The diameter of the ring-like OSF is gradually reduced in accordance with reduction of the pull-up speed, and an area with generation of the dislocation clusters comes into existence in an outer area of the ring-like OSF accordingly. The ring-like OSF then disappears, and the whole surface is occupied by the dislocation cluster defect generation area.

Fig. 1 shows the wafer of the silicon single crystal in the position A of Fig. 2 or the wafer grown at pull-up speed corresponding to the position A.

Further detailed examinations of the defect distribution show that both the IR scatterer defects and the dislocation cluster defects scarcely exist in the vicinity of the area with the ring-like OSF. An oxygen precipitation promotion area where oxygen precipitation arises depending on the treatment condition is present on the outer side adjacent to the ring-like OSF generation area, and an oxygen precipitation inhibition area causing no oxygen precipitation is present between the oxygen precipitation promotion area and a dislocation cluster generation area further outside thereof. The oxygen precipitation promotion area and the oxygen precipitation inhibition area are defect-free areas with extremely fewer Grown-in defects similarly to the ring-like OSF generation area.

The cause of these defects is not necessarily known, but can be assumed as follows. When the silicon single crystal of solid phase is grown from a melt of liquid phase, a large quantity of vacancies lacking in atoms and excessive atoms are taken into crystal lattices of solid phase in the vicinity of the solid-liquid interface. The taken vacancies or interstitial atoms disappear by mutual combining or reaching the surface by diffusion in the step of the temperature decrease with the progress of solidification. The vacancies are taken relatively more than the interstitial atoms at higher diffusion speed. Accordingly, if the cooling rate is high with an increased pull-up speed, the vacancies are remained and combined together to cause the IR scatterer defects, and if the pull-up speed is low, the vacancies disappear, and the remaining interstitial atoms form the dislocation cluster defects.

In the area in which the vacancies and the interstitial atoms are well-balanced in number, combined and extinguished, a defect-free area with extremely fewer IR scatterer defects or dislocation cluster defects is obtained. However, even within the defect-free area, the ring-like OSF is likely to generate in a position adjacent to the area with the generation of a number of IR scatterer defects. The oxygen precipitation promotion area is present on the further outside thereof or on the low speed side. The area is considered to be a defect-free area where the vacancies are predominant, thus referred to the $P_v$ area. The oxygen precipitation inhibition area is present on the further outside thereof. This area is considered to be a defect-free area where interstitial elements are predominant, thus referred to the $P_I$ area.

Since the IR scatterer defects cause no adverse effects so much as the dislocation clusters, and are effective to improve the productivity and the like, the silicon single crystal growing was conventionally performed with increased pull-up speed, so that the generation area of the ring-like OSF is located on the periphery of the crystal.

In accordance with further miniaturization of integrated circuits by recent requests of smaller sizes and higher densities, however, the IR scatterer defect also becomes a serious cause of reduction in yield of good product, and reduction of the generation density thereof has come to be an important subject. Therefore, a silicon single crystal growing method with an improved hot zone structure has been proposed to extend the defect-free area to the whole wafer surface.

In an invention disclosed in Japanese Patent Application Publication No. 8-330316, for example, when the pull-up speed in silicon single crystal growing is given by V (mm/min), and the temperature gradient in the pulling axial direction in a temperature range from a melting point to 1300°C is given by G (°C/mm), the temperature gradient is controlled so that V/G is 0.20-0.22 mm²/(°C.min) in an internal position from the crystal center to 30 mm from the outer circumference, and gradually increased toward the crystal outer circumference.

As examples of such a method for actively controlling the temperature distribution within the crystal just after solidification, inventions for a technique of making the crystal internal temperature gradient in the pulling axial direction to be large in the center part and to be small in the outer circumferential part by proper selection of the dimension and/or position of a heat shielding body surrounding the silicon single crystal, and/or by use of a cooling member and the like are disclosed in Japanese Patent Publication Nos. 2001-220289 and 2002-187794.

The crystal internal temperature gradient in the pulling axial direction is large in a peripheral part Ge and small in a central part Gc, i.e., Gc<Ge, given by Gc and Ge for a central part and a peripheral part respectively, since the silicon single crystal under pulling just after solidification is usually cooled by heat dissipation from the surface. In the inventions described in the above-mentioned Patent Documents, Gc>Ge is ensured in a temperature range from the melting point to about 1250°C by improvements of the hot zone structure by means of such as the proper selection of the dimension and/or position of the heat shielding body surrounding the silicon single crystal just after solidification, and/or the use of the cooling member.

Namely, the surface part of the silicon single crystal under pulling is thermally insulated for retention of heat, in the vicinity of a portion raised from the melt, by heat radiation from the crucible wall surface or the melt surface, and the upper part of the silicon single crystal there from is enforced to be more intensively cooled by use of the heat shielding body, the cooling member and/or the like, whereby the center part is cooled by heat transfer so as to have a relatively large temperature gradient.

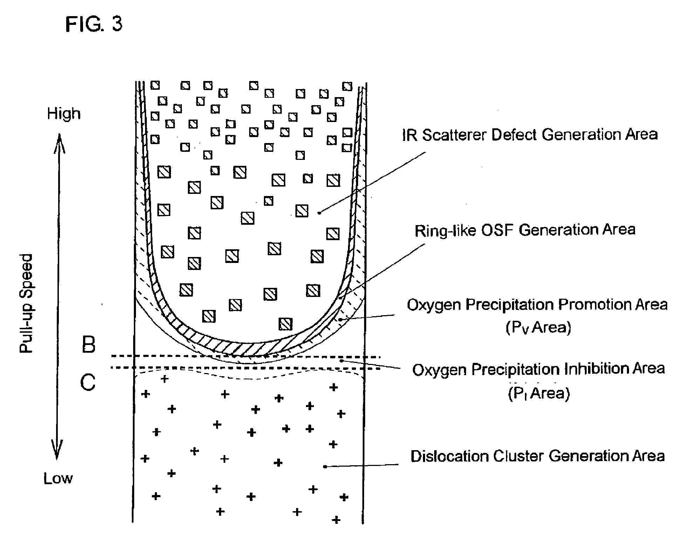

Fig. 3 is a view schematically describing the defect distribution state in a section of silicon single crystal pulled by a growing apparatus having a hot zone structure in which the temperature gradient in the pulling direction of the silicon single crystal just after solidification is smaller in the crystal peripheral part (Ge) than in the crystal center part (Gc) (Gc>Ge). Consequently, when the silicon single crystal is grown at varied pull-up speeds in the same manner as the case shown by Fig. 2, the generation distribution of each defect within the silicon single crystal is changed as shown in Fig. 3. When the pulling-growing process is performed within a speed range of B to C in Fig. 3 by use of the growing apparatus with the hot zone structure thus improved, the silicon single crystal with a trunk part mostly composed of the defect-free area is obtained, and a wafer with extremely fewer Grown-in defects can be produced.

The process for adding hydrogen to the apparatus internal atmosphere under growing is disclosed in Japanese Patent Publication Nos. 2000-281491 and 2001-335396, and the like, in which the pulling-growing process of the silicon single crystal is performed in an atmosphere with hydrogen added. In the process, when hydrogen is added to the atmosphere, hydrogen is blended into silicon melt according to its quantity, partially taken into the solidifying silicon single crystal and, consequently, the number of the Grown-in defects is reduced with a decrease in size thereof.

It is assumed that hydrogen taken into the crystal in the form of doping couples with vacancies inhibits the dispersing behavior of the vacancies, or reduces the intake of interstitial atoms due to the same effect as the interstitial atoms, while it easily diffuses and disperses at high temperature in the cooling process, thus likely resulting in the reduction of the defects. However, since it is impossible to perfectly eliminate the defects only by the addition of hydrogen to the atmosphere, a wafer cut out from the silicon single crystal thus obtained is made into a defect-free wafer by further performing a heat treatment thereto at high temperature in an atmosphere containing hydrogen.

In International Publication WO2004/083496, an invention for a method for growing a silicon single crystal free from the Grown-in defects using the effect of hydrogen is disclosed, in which using a growing apparatus with a hot zone structure improved to ensure above-mentioned Ge<Gc, pulling is performed while supplying hydrogen-containing inert gas into the apparatus.

When the temperature distribution within the silicon single crystal just after solidification is set to Ge<Gc, a pull-up speed range capable of making the whole surface of a wafer section as shown by B-C of Fig. 3 to an area free from the Grown-in defects is obtained, and growing at this pull-up speed enables formation of the silicon single crystal entirely free from defects. However, since this speed range is narrow, an increased diameter of the silicon single crystal makes it impossible to obtain the speed range capable of making the whole wafer surface into the defect-free area, or makes it difficult to stably make the straight body portion of the silicon single crystal free from defects throughout the length.

According to the inventive method of International Publication WO2004/083496, since the window between B-C of Fig. 3 is extended to widen the pull-up speed range capable of making the whole wafer surface into the defect-free area, the silicon single crystal free from the Grown-in defects can be easily grown at speed higher than in the past.

DISCLOSURE OF THE INVENTION

The present invention relates to a method for growing a silicon single crystal with extremely fewer Grown-in defects. As a technique of growing the defect-free silicon single crystal, it is known to use an apparatus with a hot zone structure adopted so that the temperature gradient in the pulling axial direction of the silicon single crystal just after solidification is larger in the center part than in the outer circumferential part, and to limit the pull-up speed.

The present invention has an object to provide a method capable of more stably providing defect-free silicon single crystal in the above-mentioned production process, and having flexibility to produce either silicon single crystal for obtaining a wafer with a defect called bulk-micro-defect (BMD) having the gettering effect or silicon single crystal for obtaining a wafer free from BMD, and silicon wafers from these silicon single crystals as demanded.

The gist of the present invention resides in the following silicon single crystal growing methods by the CZ process of (1).

(1) A method for growing a silicon single crystal by the CZ process, comprising the steps of setting hydrogen partial pressure in an inert atmosphere within a growing apparatus to 40 Pa or more and 160 Pa or less, and growing a body portion of the silicon single crystal as a vacancy-predominant defect-free area (Pv area).

According to the method for growing a silicon single crystal of the present invention, the formation of the silicon single crystal either having the vacancy predominant defect-free area ($P_V$ area) or having the interstitial silicon predominant defect-free area ($P_I$ area) over the whole area of a part for cutting out a wafer can be easily adapted, whereby either a wafer needing BMD or a wafer needing no BMD can be formed selectively according to requests, and further, a SIMOX type or bonded type SOI substrate free from defects can be stably produced.

BRIEF DESCRIPTION OF THE DRAWINGS

Fig. 1 is a view schematically showing an example of typical defect distribution observed in a silicon wafer;
Fig. 2 is a view schematically illustrating a general relation between pull-up speed and crystal defect generation position in pulling up the silicon single crystal by a defect distribution state in a section of silicon single crystal grown while gradually reducing the pull-up speed;

Fig. 3 is an illustrative view in the same manner as Fig. 2 for the silicon single crystal grown by performing the pulling by a growing apparatus having a hot zone structure adapted so that the temperature gradient in pulling direction of the silicon single crystal just after solidification is smaller in a crystal peripheral part (Ge) than in a crystal center part (Gc) or (Gc>Ge);

Fig. 4 is a view showing a case that in pulling by the same growing apparatus as in Fig. 3 hydrogen is further added to the inert atmosphere within the apparatus;

Fig. 5 is a view showing the relation between the hydrogen partial pressure and the pull-up speed range for generating a defect-free area in a case that hydrogen is added to the inert atmosphere within the growing apparatus with the hot zone structure of Gc>Ge;

Fig. 6 is a view schematically illustrating a configuration example of a silicon single crystal growing apparatus used in producing Examples;

Fig. 7 is a graph showing the distribution of oxygen precipitate generation within a wafer with an increased oxygen concentration; and

Fig. 8 is a view showing the distribution of oxygen precipitate generation within a wafer with a reduced oxygen concentration.

BEST MODE FOR CARRYING OUT THE INVENTION

In order to obtain a wafer being uniform over the whole wafer surface and free from Grown-in defects, the present inventors have made various investigations for the effects of setting Ge<Gc for the crystal internal temperature distribution during pulling as well as adding hydrogen to the apparatus internal atmosphere.

It is described in International Publication WO 2004/083496 that the apparatus internal atmosphere is configured to be an inert gas atmosphere with hydrogen added thereto, whereby the pull-up speed range capable of providing an area free from the Grown-in defects can be extended, and defect-free silicon single crystal can be grown at pull-up speed higher than in the past.

However, as a result of the attempts of growing silicon single crystal by the method described in International Publication WO 2004/083496, it was found that the limit range of hydrogen partial pressure was far extensive and its effect is not always clearly shown. Therefore, the influence of the extent of hydrogen partial pressure was further examined. As a result, it became clear that a new effect emerges when the hydrogen partial pressure is limited to a specified range.

It is assumed that the effect obtained by mixing hydrogen into the internal atmosphere gas in the apparatus during growing is caused by that the hydrogen contained in a chemically inactive gas such as argon, which is generally used as the atmosphere gas, is migrated and blended into silicon melt in proportion to the hydrogen partial pressure, and distributed into the solidifying the silicon crystal.

The hydrogen which migrates and blends into the melt is meager since the quantity of hydrogen mixed into the atmosphere is small, and the inside space of apparatus is kept in a reduced pressure lower than the atmospheric pressure. Accordingly, the relation that the concentration $L_H$ of hydrogen in a state where the blending quantity is equilibrated is proportional to the hydrogen partial pressure $P_H$ in the atmosphere, or the Henry's law for a diluted solution of an element in a gas phase expressed by the following formula should be established.

$$L_H = kP_H \ (\text{k coefficient}) \qquad (1)$$

In this regard, the defect generation state was examined by use of a growing apparatus with an improved hot zone structure by variously changing the hydrogen partial pressure in the atmosphere and the pull-up speed. The hydrogen partial pressure in the atmosphere is represented by the following equation, given that atmospheric gas pressure in the inside of apparatus is $P_0$, and the volume ratio of the hydrogen contained in the atmospheric gas introduced is $X(\%)$.

$$P_H = P_0 X/100 \qquad (2)$$

Accordingly, to hold the hydrogen partial pressure or the hydrogen concentration within the melt in constant at different atmospheric gas pressures within the apparatus, the volume ratio of hydrogen to be mixed must be changed according to the equation (2).

Growing of the silicon single crystal was therefore carried out by variously selecting the hydrogen partial pressure within the apparatus and continuously changing the pull-up speed, and the morphology of the defect distribution was examined in the same manner as in Fig. 2 or 3.

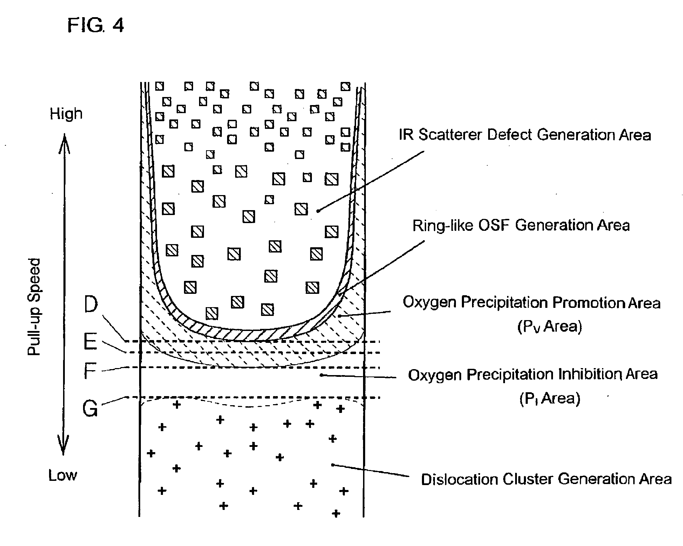

Fig. 4 schematically shows the defect distribution state in a section of the silicon single crystal pulled with further addition of hydrogen to the inert atmosphere within the pulling apparatus by the same growing apparatus as in Fig. 3. In the case shown in Fig. 4, the silicon single crystal was grown by continuously changing the pull-up speed under an atmospheric hydrogen partial pressure set to 250 Pa.

As is apparent from the mutual comparison of Figs. 4 and 3, the window of the defect-free area in pulling direction is extended by adding hydrogen to the atmosphere. Namely, the allowable range of the pull-up speed capable of producing an area of the same characteristic is increased. Accordingly, if the pull-up speed in the range of D-E is selected in Fig. 4, a wafer with the $P_V$ area (oxygen precipitation promotion area or vacancy-predominant defect-free area) can be obtained substantially over the whole surface, and if the pull-up speed in the range of F-G is selected, a wafer with the $P_I$ area (oxygen precipitation inhibition area or interstitial silicon-predominant defect-free area) can be obtained over the whole surface.

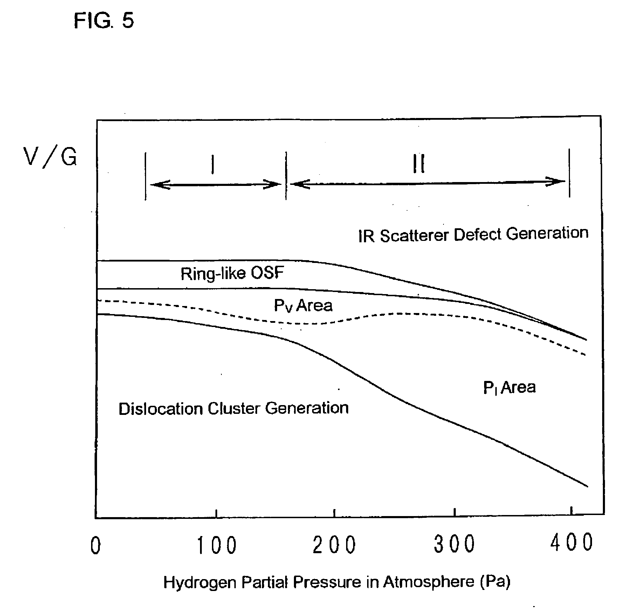

Fig. 5 is a view illustrating the relation between the hydrogen partial pressure and the pull-up speed range capable of generating the defect-free area in the case that hydrogen is added to the inert atmosphere within the same growing apparatus as in Fig. 3. In Fig. 5, the difference in generation of the Grown-in defects depending on the pull-up speed in the center part of the growing silicon single crystal was examined by variously changing the atmospheric hydrogen partial pressure, and as the result, a clear tendency could be observed.

Since the internal temperature distribution of the silicon single crystal during pulling is hardly changed even if the pull-up speed is changed with having the same hot zone structure, the vertical axis in Fig. 5 can be regarded as the pull-up speed. Either the ring-like OSF area, the $P_V$ area or the $P_I$ area is a defect-free area free from the Grown-in defects. As is apparent from Fig. 5, although the pull-up speed capable of providing the defect-free area reduces in accordance with an increase of the hydrogen partial pressure in the atmosphere, the range of the speed is extended as the hydrogen partial pressure is increased.

With respect to the respective pull-up speed ranges for the OSF area, the PV area and the $P_I$ area, the range for the OSF area is narrowed when the hydrogen partial pressure increases, and finally disappears depending on the oxygen concentration.

The OSF area, which is an area with less Grown-in defects, is apt to cause a secondary defect by oxygen precipitation, and it is preferable to avoid the generation of this area if possible. The $P_V$ area is an area free from the Grown-in defects and capable of forming BMD. This area is extended or narrowed depending on an increase/decrease of the hydrogen partial pressure, in which the speed range is high at relatively low hydrogen partial pressure. The $P_I$ area is narrow at low hydrogen partial pressure, but largely extended when the hydrogen partial pressure increases.

The reason that the pull-up speed range capable of providing the defect-free area is changed by altering the partial pressure of hydrogen by adding hydrogen to the atmosphere during growing is not necessarily clarified. However, from a report that when a silicon wafer heated at a high temperature close to the melting point is quenched in hydrogen, a hydrogen composite made of hydrogen bonded with vacancy or interstitial silicon is observed, it is supposed that the hydrogen taken into the crystal just after solidification has any interaction with vacancies or interstitial atoms.

Assuming that the hydrogen is bonded with vacancies to inhibit the movement of the vacancies, the hydrogen might inhibit generation of the IR scatterer defects which are formed by aggregation of the vacancies to extend the OSF area or the $P_V$ area. On the other hand, since hydrogen is an element intruded into lattice interstices of the silicon crystal, the presence of a large quantity of hydrogen may have the same effect as an increased concentration of interstitial atoms of silicon, reducing the number of interstitial atoms of silicon to be taken into the crystal from the melt in the process of solidification. Therefore, as shown in Fig. 5, an increased hydrogen partial pressure will inhibit generation of dislocation clusters resulted from the interstitial atoms and help shift the defect-free area to the lower side in terms of pull-up speed, resulting in a significant extension of the $P_I$ area.

Most of hydrogen intervening the formation of the Grown-in defects conceivably dissipates out of the silicon single crystal in the subsequent cooling process.

As described above, it was found that in the growing apparatus in which the hot zone structure is improved to extend the defect-free area on the wafer surface or on the plane perpendicular to the pulling axis, the pull-up speed range capable of providing the defect-free area can be extended by further adding hydrogen to the internal atmosphere of the apparatus, and the respective ranges for the OSF area, the $P_V$ area, and the $P_I$ area within the defect-free area can be changed by altering the hydrogen partial pressure. From the above-mentioned result of Fig. 5, potentialities as described in (a), (b) and (c) are conceivable.

(a) Since the pull-up speed range for forming the defect-free area is extended, the characteristic scatter within a wafer radial directions can be reduced, and a defect-free wafer with a large diameter can be easily produced. With just improving the hot zone structure, the pull-up speed range for making the whole wafer to the defect-free area was narrow, strict pull-up speed control was needed to obtain a defect-free wafer having the same performance over the whole wafer and, particularly, the scatter of characteristics in a wafer was increased at an increased diameter of the silicon single crystal to make its application difficult.

(b) The extension of the pull-up speed range enables flexible formation of either a defect-free wafer with BMD or a defect-free wafer without BMD. For example, since the pull-up speed range for providing the $P_V$ area is extended by controlling the hydrogen partial pressure to the range indicated by I in Fig. 5, a wafer with the $P_V$ area over the whole wafer can be easily produced, while controlling to the range indicated by II facilitates the production of a wafer with the $P_I$ area over the whole wafer. Accordingly, it becomes possible to cope with various demands for wafers depending on the usage from integrated circuit producing customers, such as ones including a defect-free wafer but needing BMD and a defect-free wafer needing no BMD used for SIMOX (separation-by-implanted-oxygen) or bonded SOI (silicon-on-insulator) substrate.

(c) Since the OSF can be contracted, a defect-free wafer with increased oxygen can be produced.

Whether these potentialities can be realized was examined, and the limitation to realization thereof were further cleared, whereby the present invention was completed. The reason to limit the scope of the present invention is described in (1)-(7).

(1) Using a growing apparatus with an improved hot zone structure, a silicon single crystal is pulled from a melt in an inert gas atmosphere containing hydrogen of partial pressure 40-400 Pa within the apparatus to grow a body portion of the silicon single crystal as a defect-free area free from the Grown-in defects.

The growing apparatus with the improved hot zone is an apparatus adapted so that the silicon single crystal during pulling from the melt has a crystal internal temperature distribution of Ge<Gc in a temperature range from the melting point to 1250°C. Such a temperature distribution enables extension of the defect-free area of the silicon single crystal in the wafer-surface-wise direction by selecting the pull-up speed. And the growing apparatus can have any hot zone structure as long as this crystal internal temperature distribution can be achieved.

The pull-up speed range for obtaining defect-free silicon single crystal is varied depending on the diameter of the silicon single crystal and the hot zone structure. Since the same range can be adopted if the apparatus and the crystal diameter are the same, the silicon single crystal is preliminarily grown while continuously changing the pull-up speed, and then the speed range can be examined and selected based thereon.

The reason for setting the atmospheric hydrogen partial pressure in the apparatus to 40-400Pa is that the pull-up speed range capable of providing the defect-free area can be further extended. The effect of including hydrogen in the atmosphere cannot be sufficiently obtained at less than 40Pa, while a giant cavity defect called a hydrogen defect is likely to generate at a hydrogen partial pressure exceeding 400 Pa. The gas pressure of the apparatus internal atmosphere is not necessarily limited in particular if the hydrogen partial pressure is within the above range, and any generally applicable condition can be adopted.

(2) A body portion of silicon single crystal is grown as a vacancy predominant defect-free area with a hydrogen partial pressure in the apparatus internal atmosphere of 40 Pa or more and 160 Pa or less.

The silicon single crystal with a vacancy-predominant defect-free area ($P_V$ area) over the whole wafer can be easily grown by setting the hydrogen partial pressure to 40 Pa or more and 160 Pa or less, which is within the range of above (1), and by selecting the pull-up speed. The reason for setting the hydrogen partial pressure to 40 Pa or more is that the pull-up speed range for obtaining the defect-free area is narrow at less than 40 Pa, and the reason for setting the partial pressure to 160 Pa or less is that a wafer including the $P_I$ area is likely to be formed at a pressure exceeding 160 Pa.

The wafer with the $P_V$ area is likely to form an oxygen precipitate, and for example, when a so-called DZ (denuded zone) layer forming treatment is applied to the surface, BMD having the gettering effect is easily formed in the inner part. It is difficult to form BMD in the $P_I$ area.

(3) A body portion of silicon single crystal is grown as an interstitial silicon-predominant defect-free area with a hydrogen partial pressure in the device internal atmosphere of more than 160 Pa and 400 Pa or less.

The silicon single crystal with the $P_I$ area over the whole wafer surface can be easily grown by setting the hydrogen partial pressure more than 160Pa and 400 Pa or less, which is within the range of above (1), and by selecting the pull-up speed. The reason for setting the hydrogen partial pressure to more than 160 Pa is that the $P_V$ area might be included in the wafer at 160 Pa or less, and the reason for setting the pressure to 400 Pa or less is that the partial pressure exceeding 400 Pa is likely to cause a giant cavity defect.

Even in a wafer free from the Grown-in defects, an oxygen precipitate is likely to generate in the vacancy-predominant defect-free area, and there is an occasion which requires to avoid the generation of oxygen precipitate and secondary defects thereby in a device active area for forming circuits as much as possible. In such a case, reducing the oxygen concentration suffices therefor, but the reduction in oxygen has a limitation since it deteriorates the wafer strength, so that the wafer can be deformed even with a small stress, causing dislocation generation. In contrast, no oxygen precipitate is generated in the $P_I$ area, and oxygen can be kept at high level. However, it was difficult to grow the silicon single crystal with the $P_I$ area over the whole wafer in the past.

(4) It is sufficient enough for a gas of a hydrogen-atom-containing substance to be added during the time when a body portion that constitutes a required diameter of silicon single crystal is pulled, in order to include hydrogen in the inert atmosphere within the apparatus.

Inclusion of hydrogen is not needed in stages of such as polycrystal fusion, degasification, immersion of seed crystal, necking, and formation of shoulder in a crucible under the inert gas atmosphere. In the stage of reducing the diameter to form a cone after the end of growth and separating it from the melt, also, it is not needed to include hydrogen in the atmosphere gas to be introduced into the apparatus. Since hydrogen can be easily blended into the melt in a short time, the effect can be sufficiently obtained only by including the hydrogen in the atmosphere just during the time of pulling the body portion. From the point of ensuring the safety in handling hydrogen, it is preferable not to use hydrogen more than in need.

The hydrogen-atom-containing substance intended by the present invention is a substance which can be thermally decomposed when blended into silicon melt to supply a hydrogen atom to the silicon melt. This hydrogen-atom-containing substance is introduced into the inert gas atmosphere, whereby the hydrogen concentration in the silicon melt can be improved.

Concrete examples of the hydrogen-atom-containing substance include an inorganic compound containing hydrogen atom such as hydrogen gas, $H_2O$ or $HCl$, a hydrocarbon such as silane gas, $CH_4$, or $C_2H_2$, and various substances containing hydrogen atoms such as alcohol or carboxylic acid. Particularly, the use of hydrogen gas is desirable. As the inert gas, an inexpensive Ar gas is preferred, and a single substance of various kinds of rare gas such as He, Ne, Kr or Xe, or mixed gas thereof can be used.

When oxygen gas ($O_2$) is present in the inert atmosphere, the hydrogen-atom-containing gas can exist at a concentration such that the concentration difference between the concentration of the gas in terms of hydrogen molecule and the double of the concentration of oxygen gas is 3 vol. % or more. When the concentration difference between the concentration of the hydrogen-atom-containing gas in terms of hydrogen molecule and the double of the concentration of the oxygen gas is less than 3 vol. %, the effect on inhibiting the generation of the Grown-in defects such as a COP and a dislocation cluster by the hydrogen atom taken into the silicon crystal cannot be obtained.

Since a high nitrogen concentration in the inert atmosphere might cause dislocation of the silicon crystal, the nitrogen concentration is preferably set to 20% or less within a normal furnace internal pressure of 1.3-13.3 kPa (10-100 Torr).

In the addition of hydrogen gas as the hydrogen-atom-containing substance gas, the hydrogen gas can be supplied to the inert atmosphere within the apparatus from a commercially available hydrogen gas cylinder, a hydrogen gas storage tank, a tank filled with a hydrogen absorbing alloy or the like through an exclusive outfitted conduit.

(5) Wafers cut from silicon single crystals obtained in above (1)-(4) can be subjected to rapid thermal annealing (RTA) treatment, for example, in an inert gas atmosphere or in a mixed atmosphere of ammonia and inert gas under the condition of heating temperature 800-1200°C and heating time 1-600 min. Vacancies are injected into the wafers by performing the RTA treatment in the inert gas atmosphere or in the mixed atmosphere of ammonia and inert gas.

Since the wafer intended by the present invention is a silicon wafer composed of a defect-free area and free from an aggregate of point defects, interstitial silicon type point defects which annihilate the injected vacancies are hardly present therein, and vacancies necessary for oxygen precipitation can be efficiently injected. Since vacancy type point defects are hardly present as well, a sufficient vacancy density can be ensured by the RTA treatment.

A heat treatment is performed in the subsequent low-temperature process for device, whereby the precipitation of oxygen to vacancies is promoted with stabilization of oxygen precipitation nucleus by the heat treatment, and the growth of precipitates is performed. Namely, this RTA treatment enables sufficient homogenization of the oxygen precipitation within the wafer surface and improvement of the gettering capability in the surface layer part in the vicinity of the outermost surface layer of wafer in which a device structure is to be formed.

(6) A defect-free silicon wafer having an oxygen concentration of $1.2 \times 10^{18}$ atoms/cm$^3$ (ASTM F 121, 1979) or more can be produced.

Conventionally, the oxygen concentration of silicon single crystal is limited to $1.2 \times 10^{18}$ atoms/cm$^3$ or less, since an increased oxygen concentration in wafer facilitates generation of oxygen precipitates and secondary defects in the device active area to deteriorate circuit characteristics. In the method of the present invention, in contrast, the oxygen precipitation in the device active area can be inhibited even with an oxygen concentration of $1.2 \times 10^{18}$ atoms/cm$^3$ or more.

Therefore, the generation quantity of BMD can be increased in a wafer with the OSF and $P_V$ areas, and the strength can be improved in a wafer with the $P_I$ area. Conceivably, such an effect may be attributable to the reduction in precipitation sites of oxygen precipitates by the interaction between hydrogen and vacancies.

Particularly, a wafer with the $P_I$ area over the whole surface and an increased oxygen concentration is suitable for a wafer to be subjected to RTA treatment, because it can satisfy both the formation of a defect-free surface activated area and the generation of BMD in the inner part.

However, since an excessively high oxygen concentration extinguishes this precipitation inhibition effect, the oxygen concentration is up to $1.6 \times 10^{18}$ atoms/cm$^3$ at a maximum.

(7) A defect-free silicon wafer with an oxygen concentration of $1.0 \times 10^{18}$ atoms/cm$^3$ (ASTM F121, 1979) or less, which is free from oxygen precipitates, can be produced.

To respond to requests of higher speed and lower power consumption due to high integration of integrated circuits, dielectric isolation between device elements becomes an important problem. Substrates of SOI structure have been frequently used in responding to this problem. These SOI substrates include SIMOX type, bonded type and the like, each of which needs suppression of the IR scatterer defects and oxygen precipitation as much as possible. Using a wafer composed of the $P_I$ area is sufficient for this purpose. In order to obtain a further excellent substrate, the oxygen concentration is preferably set to $1.0 \times 10^{18}$ atoms/cm$^3$ or less.

EXAMPLES

[Example 1]

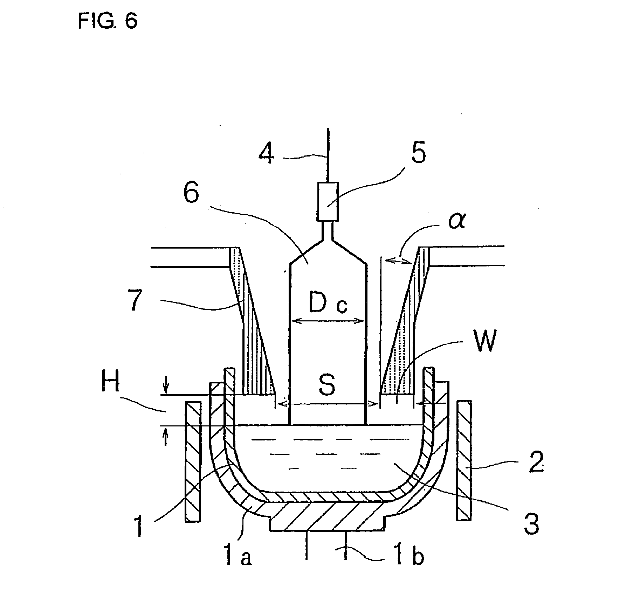

A growing experiment was carried out by use of an apparatus having a sectional structure schematically shown in Fig. 6. In this drawing, a heat shielding cone 7 has a structure consisting of an outer shell made of graphite and the interia filled with graphite felt therein, with an outer diameter of a portion to be put into a crucible of 480 mm, a minimum inside diameter S at the bottom end of 270 mm, and a radial width W of 105 mm, the inner surface of which is a reverse truncated conical face started from the lower end with an inclination of 21° with respect to the vertical direction. The crucible 1 has an inside diameter of 550 mm, and the height H of the lower end of the heat shielding body 7 from melt surface is 60 mm.
In this growing apparatus, the heat shielding cone 7 is set to have a large thickness for a lower end part and a large height H of its lower endmost from the melt surface, so that the temperature distribution within the silicon single crystal pulled up from the melt satisfies Gc<Ge in a temperature range of from the melting point to 1250°C.
Polycrystal of high purity silicon was charged in the crucible, and the crucible was heated by a heater 2 while laying the apparatus in a pressure-reduced atmosphere to melt the silicon into melt 3. A seed crystal attached to a seed chuck 5 was immersed in the melt 3 and pulled up while rotating the crucible 1 and a pulling shaft 4. After seed tightening for making crystal dislocation free was performed, a shoulder part was formed followed by shoulder changing, and a body portion was then formed.
Using the growing apparatus having the hot zone structure shown in Fig. 6, the silicon single crystal was grown with a target diameter of a body portion of 200mm; axial internal temperature gradients of the single crystal under growing of 3.0-3.2°C /mm in the center part and 2.3-2.5°C /mm in the peripheral part within a temperature range from the melting point to 1370°C; and an apparatus internal atmospheric pressure of 4000 Pa, while changing the pull-up speed to 0.6mm/min to 0.3 mm/min to 0.6 mm/min. In this case, the growing was carried out by changing the hydrogen partial pressure of the apparatus internal atmosphere to following 6 levels, 0 without addition of hydrogen, and 20 Pa, 40Pa, 160 Pa, 240 Pa and 400 Pa with addition of hydrogen gas.
The resulting silicon single crystal was vertically cut along the pulling axis to prepare a sheet-like test piece including the vicinity of the pulling axis in plane, and distribution of the Grown-in defects therein was observed. In the observation, the piece was immersed in an aqueous solution of copper sulfide followed by drying, heated in nitrogen atmosphere at 900°C for 20 minutes followed by cooling, and immersed in a hydrofluoric acid-nitric acid mixture to remove a Cu-silicide layer in the surface layer by etching, and the position of OSF ring or the distribution of each defect area were examined by X-ray topography. The examination result is shown in Table 1.

Table 1

| Pull-up speed range of each area | Hydrogen partial pressure of growing apparatus internal atmosphere | | | | | |
|---|---|---|---|---|---|---|
| | 0 | 20Pa | 40Pa | 160Pa | 240Pa | 400Pa |
| Area free from Grown-in defects (mm/min) | 0.0384 | 0.0381 | 0.0425 | 0.0502 | 0.0616 | 0.0767 |
| OSF area (mm/min) | 0.0221 | 0.0210 | 0.0216 | 0.0222 | 0.0087 | - |
| $P_v$ area (mm/min) | 0.0054 | 0.0055 | 0.0126 | 0.0217 | 0.0130 | 0.0117 |
| $P_I$ area (mm/min) | 0.0110 | 0.0108 | 0.0102 | 0.0121 | 0.0405 | 0.0673 |

The numerical values in Table 1 show the speed range where the respective areas emerge. For the area free from the Grown-in defects, the numerical value shows the speed range where no defect is present in the radial direction of the crystal or over the whole area of the wafer surface. Each speed range for the OSF, $P_v$ and $P_I$ areas is the pulling axial range in the crystal center, and the sum of these three speed ranges is substantially equal to the speed range of the area free from the Grown-in defects.

With respect to the $P_v$, the speed range is increased from 2 times to 4 times by setting the hydrogen partial pressure to 40-160 Pa, compared with the case that no hydrogen is included in the atmosphere. The speed range of the P, is extended from 4 times to 6 times as is apparent from the results of 240Pa and 400 Pa.

[Example 2]

Using the growing apparatus used in Example 1, with respect to two kinds of silicon single crystals with oxygen concentrations of $1.24 \times 10^{18}$ atoms/cm$^3$ and $1,07 \times 10^{18}$ atoms/cm$^3$, silicon single crystal growing for obtaining defect-free wafers was carried out by varying the pull-up speed and the hydrogen partial pressure in the atmosphere under the condition shown in Table 2.

Table 2

| Oxygen initial concentration | Hydrogen partial pressure | Pull-up speed | Notes |
|---|---|---|---|
| $1.24 \times 10^{18}$ (atoms/cm$^3$) | 0 | 0.387 mm/min | Comparative wafer |
| | 120 Pa | 0.382 mm/min | $P_v$ wafer |
| | 320 Pa | 0.362 mm/min | $P_l$ wafer |
| $1.07 \times 10^{18}$ (atoms/cm$^3$) | 0 | 0.389 mm/min | Comparative wafer |
| | 120 Pa | 0.381 mm/min | $P_v$ wafer |
| | 320 Pa | 0.359 mm/min | PI wafer |

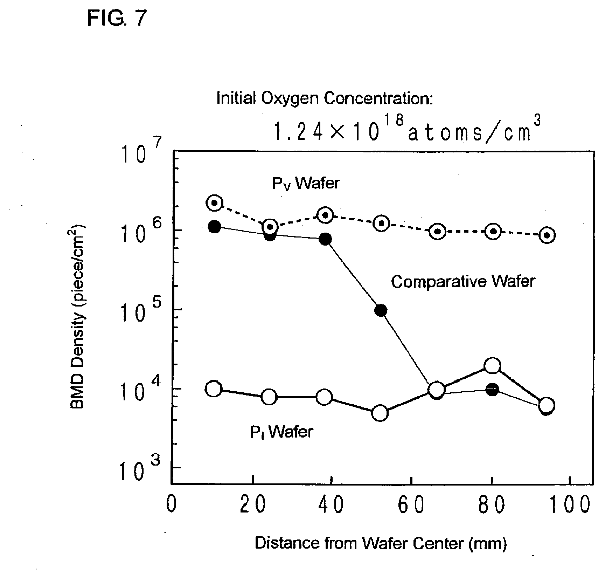

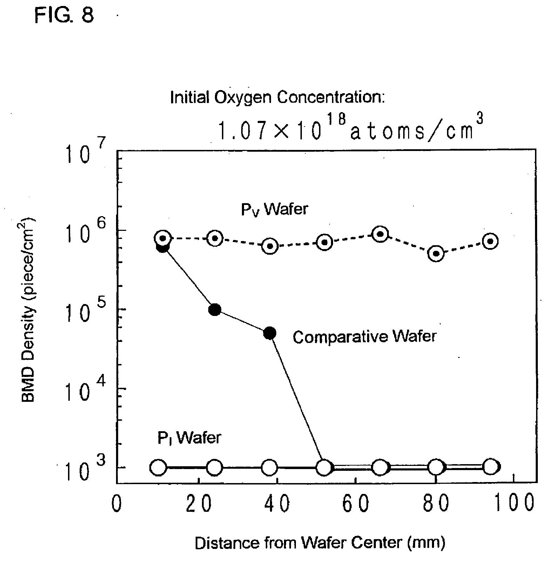

To know the generation state of BMD in wafer, wafers were collected from substantially the center of the resulting silicon single crystals, and heated at 800°C for 4 hours and then at 1000°C for 16 hours followed by 2 μm-light -etching at cleaved surfaces, and the density of precipitates was measured therefor. The density distributions of the precipitates that are BMD in the radial direction are shown in Figs. 7 and 8.

In the drawings, the results of BMD in wafer for defect-free wafers produced without addition of hydrogen to the atmosphere are shown as comparative wafers. In this case, defect-free wafers can be obtained, but the formation quantity of BMD was varied depending on the position of wafer, and it was difficult to form BMD in a uniform quantity over the whole wafer.

In contrast, by adding hydrogen gas to the atmosphere while controlling the partial pressure thereof, and selecting the pull-up speed, a $P_v$ wafer with a sufficient quantity of BMD formed substantially uniformly on the whole surface or a $P_l$ wafer in which BMD is hardly generated in uniform manner on the whole wafer can be selectively formed.

When the oxygen concentration is high, a wafer capable of substantially forming a sufficient quantity of BMD in uniform manner can be obtained as shown in Fig. 7, and by reducing the oxygen concentration, a defect-free wafer with extremely fewer BMD suitable for a SOI substrate can be obtained as shown in Fig. 8.

INDUSTRIAL APPLICABILITY

A silicon single crystal is produced by the CZ process by setting a hydrogen partial pressure in an inert atmosphere within a growing apparatus to 40 Pa or more but 400 Pa or less, and by growing a body portion of the silicon single crystal as a defect-free area free from the Grown-in defects. Therefore, a wafer the whole surface of which is composed of the defect-free area free from the Grown-in defects and which can sufficiently and uniformly form BMD can be easily produced. Such a wafer can be extensively used, since it can significantly reduce generation of characteristic defectives of integrated circuits to be formed thereon and contribute for improving the production yield as a substrate responding to the demand for further miniaturization and higher density of the circuits.

**Claims**

1. A method for growing a silicon single crystal by the Czochralski process, **characterized in that**:

   a gas of a hydrogen atom-containing substance is added to the inert atmosphere within the growing apparatus only for the period of growing the body portion of the silicon single crystal;

hydrogen partial pressure is set in an inert atmosphere within a growing apparatus to 40 Pa or more and 160 Pa or less; and

a body portion of the silicon single crystal is grown as a vacancy-predominant defect-free area.

**Patentansprüche**

1. Verfahren zum Wachsen eines Siliziumeinkristalls durch das Czochralski-Verfahren, **dadurch gekennzeichnet dass**:

   ein Gas einer Wasserstoffatome enthaltenden Substanz nur für die Dauer eines Wachstums des Hauptteils des Siliziumeinkristalls der inerten Atmosphäre innerhalb der Wachstumsvorrichtung zugefügt wird;
   ein Wasserstoffpartialdruck in einer inerten Atmosphäre innerhalb einer Wachstumsvorrichtung auf 40 Pa oder mehr und 160 Pa oder weniger eingestellt wird; und
   ein Hauptteil des Siliziumeinkristalls als defektfreier Bereich mit Gitterleerstellen-Übergewicht gewachsen wird.

**Revendications**

1. Un procédé pour faire croître un monocristal de silicium, par le procédé Czochralski, **caractérisé en ce que**:

   - un gaz d'une substance contenant de l'atome d'hydrogène est ajouté à une atmosphère inerte régnant dans l'appareil où se produit la croissance uniquement pendant la période de croissance de la partie de corps du monocristal de silicium;
   - la pression partielle d'hydrogène est réglée dans l'appareil de croissance dans une atmosphère inerte à plus de 40 Pa et égale ou supérieure à 160 Pa; et
   - une partie de corps du monocristal de silicium est amenée à croitre en tant que zone exempte de défauts où les lacunes prédominent..

FIG. 1

IR Scatterer Defect

Ring-like OSF

Oxygen Precipitation Promotion Area

Oxygen Precipitation Inhibition Area

Dislocation Cluster Defect

FIG. 2

High

Pull-up Speed

Low

A

IR Scatterer Defect Generation Area

Ring-like OSF Generation Area

Oxygen Precipitation Promotion Area

Oxygen Precipitation Inhibition Area

Dislocation Cluster Generation Area

FIG. 3

FIG. 4

IR Scatterer Defect Generation Area

Ring-like OSF Generation Area

Oxygen Precipitation Promotion Area
(P$_V$ Area)

Oxygen Precipitation Inhibition Area
(P$_I$ Area)

Dislocation Cluster Generation Area

High

Low

Pull-up Speed

D
E
F
G

FIG. 5

FIG. 6

FIG. 7

Initial Oxygen Concentration:
$1.24 \times 10^{18}$ atoms/cm$^3$

FIG. 8

Initial Oxygen Concentration:
$1.07 \times 10^{18}$ atoms/cm³

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8330316 A
- JP 2001220289 A
- JP 2002187794 A
- JP 2000281491 A
- JP 2001335396 A
- WO 2004083496 A